# EUROPEAN PATENT SPECIFICATION

(11) **EP 2 020 689 B1**
(45) Date of publication and mention of the grant of the patent: **20.02.2019**
(21) Application number: 07739038.3
(22) Date of filing: 20.03.2007
(51) Int. Cl.: H01L 31/04, G05F 1/67

(54) **SOLAR PHOTOVOLTAIC POWER GENERATION ARTIFICIAL-POWER GENERATING METHOD AND SOLAR PHOTOVOLTAIC POWER GENERATION SIMULATOR POWER-SUPPLY APPARATUS**
VERFAHREN ZUR ERZEUGUNG VON KÜNSTLICHEM STROM MIT PHOTOVOLTAISCHER SOLARSTROMERZEUGUNG UND STROMVERSORGUNGSVORRICHTUNG FÜR EINEN SIMULATOR DER PHOTOVOLTAISCHEN SOLARSTROMERZEUGUNG
PROCÉDÉ DE PRODUCTION D'ÉNERGIE ARTIFICIELLE POUR LA PRODUCTION D'ÉNERGIE PHOTOVOLTAIQUE SOLAIRE ET APPAREIL D'ALIMENTATION SIMULANT LA PRODUCTION D'ÉNERGIE PHOTOVOLTAIQUE SOLAIRE

(30) Priority: 26.04.2006 JP 2006121443
(43) Date of publication of application: 04.02.2009
(73) Proprietor: Sansha Electric Manufacturing Co., Ltd., Osaka 533-0031 (JP)
(72) Inventor: YUGUCHI, Takashi, Osaka-shi, Osaka 533-0031 (JP); MAKITANI, Atsushi, Osaka-shi, Osaka 533-0031 (JP); YAMAMOTO, Hajime, Osaka-shi, Osaka 533-0031 (JP)
(74) Representative: Ganahl, Bernhard
(86) International application number: PCT/JP2007/055595
(87) International publication number: WO 2007/125695

(56) References cited:
- JP-A- 07 234 716
- JP-A- 09 091 051
- JP-A- 2003 324 207
- JP-A- 2004 260 944
- JP-A- 2004 297 880

## Description

### TECHNICAL FIELD

The present invention relates to an input power supply necessary for the completion test of a solar photovoltaic power generation inverter. More specifically, the present invention relates to a solar photovoltaic power generation simulator power supply which artificially reproduces and outputs the output characteristic of a solar photovoltaic power generation module.

### BACKGROUND ART

The trend of a solar photovoltaic power generation system is toward larger capacitance. For instance, in a 1,000 kVA inverter completion test, in place of permanently installing a 1,200 kW class-solar battery panel, an artificial power-supply apparatus, as a testing power supply, which is lower in installation cost and is easier to handle has been required. The artificial power-supply apparatus is a power-supply apparatus which is connected to the input side of the solar photovoltaic power generation inverter and artificially generates the output current/voltage characteristic of the solar battery. The technical disclosure which can be referred as a characteristic value of the power supply satisfying the requirements is described in Patent Citation 1.

A necessary number of solar battery modules are connected in series. The output thereof is connected to the input side of an inverter tested. The output characteristic (output voltage, current, and power) of the inverter connected to a fluctuating load and the inverter input voltage and current are then measured to calculate the characteristic of the efficiency of the inverter. However, in natural light irradiation, the output of the solar battery module is always fluctuated, which is unsuitable for measuring the characteristic test. The power supply is desired to artificially generate and reproduce a state that solar irradiation during measurement is stable so that the inverter input voltage and current values are stabilized to a predetermined value.

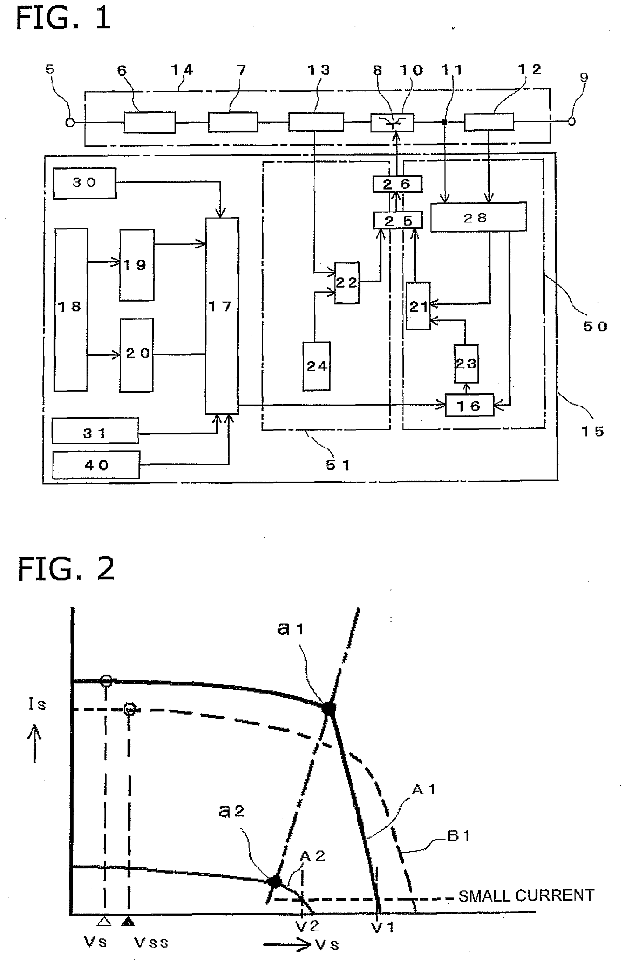

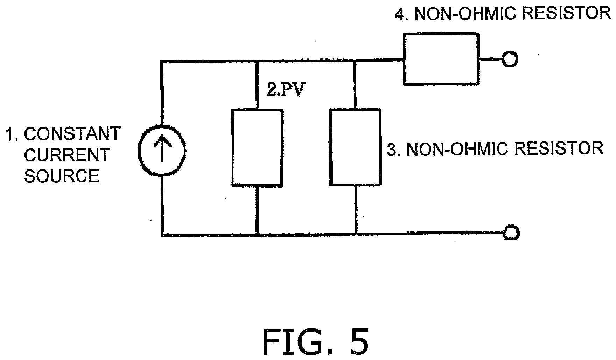

Patent Citation 1 discloses information on a power supply applicable to a simple and small load. A power supply having a large output current causes much internal power loss, which is not applicable to practical use. Patent Citation 1 (paragraph 0014) has the following description. "An example of a power-supply apparatus according to the present invention is illustrated in Fig. 1 (Fig. 5 of this specification). In the power-supply apparatus, a light-shielded solar battery 2 and a non-ohmic resistor 3 are connected in parallel to a constant current source 1, and a non-ohmic resistor 4 is connected to these in series. Various current values of the constant current source 1 can be selected and may coincide with a short-circuit current value of the solar battery in standard light (100 mW/cm²). The non-ohmic resistors 3 and 4 which have the respective voltage/current characteristics according to the desired voltage/current characteristic of the power-supply apparatus may be appropriately selected. More specifically, the non-ohmic resistor 4 for series connection which increases a resistance value with increase in applied voltage can be used. For instance, a resistance wire of relatively high resistance like a tungsten wire or a nichrome wire can be used. The non-ohmic resister 3 for parallel connection which decreases a resistance value with increase in applied voltage can be used. For instance, an SiC varistor, a selenium rectifying element, a BaTiO₃ varistor, and an Si diode varistor can be used". The problem of power loss consumed by the non-ohmic resistor for series connection in the large-capacitance power supply can generate much heat, thereby having a minus effect on the social resource saving requirement, and can stop industrialization of the large-capacitance power supply.

JPH 07234716 (A) discloses a solar power generation simulator which stores a PV characteristic (solar power generation characteristic) data based on table data obtained by means of calculating the current/ voltage characteristics of solar power generation.

JP 2003-324207 A relates to the theoretical background of generating power generation characteristics (IV curves), their empirical verification by real measurement, and the evaluation of solar panel output measurement under real conditions by transformation of IV curves obtained under ideal conditions.

Patent Citation 1: Patent 6-195140 Title: "POWER-SUPPLY APPARATUS"

### DISCLOSURE OF INVENTION

### TECHNICAL PROBLEM

The power loss consumed in the large-capacitance power-supply apparatus generates much heat, thereby having the minus effect on the social requirement. Therefore, there is provided a solar photovoltaic power generation simulator power supply apparatus which is based on a method for artificially generating the output characteristic of a solar photovoltaic power generation module with the internal power loss reduced, and a power-supply apparatus which artificially generates and outputs the output characteristic.

The invention starts out from a solar photovoltaic power generation artificial-power generating method which includes the steps of feedforward controlling a semiconductor switching element for power control based on an input current, and feedback controlling the semiconductor switching element for power control based on an output current, further including: reading a particular current/voltage values relation curve (designated IV curve) from among the output characteristics of a solar battery generated based on the annual fluctuation in the amount of solar irradiation and stored in a storage means; generating a control signal such that the output characteristic value of a direct-current power controlling unit satisfies the current/voltage relation on the IV pattern; and supplying the control signal to the semiconductor switching element for power control to control the output characteristic of the direct-current power controlling unit so as to coincide with the designated current/voltage values relation curve of the solar battery.

The solar photovoltaic power generation artificial characteristic will be described by illustrating an example. The current/voltage values relation curve from among the output characteristics of solar photovoltaic power generations will be described by illustrating only points necessary for describing the present invention in Fig. 2. A direct-current voltage, when a nearly no-load small current value indicated by the dashed line is outputted, is changed from a voltage value V1 to V2 according to the change from a curve A1 in strong solar irradiation to a curve A2 in weak solar irradiation. The voltage output is V1 in daytime solar irradiation and the voltage value is V2 immediately before sunset. A first IV reading means reads the curve A2 from among the IV curves stored in the IV storing means. A second IV reading means reads the voltage value V2 which coincides with the small current indicated by the dashed line. Assuming the inverter operation immediately before sunset, the direct-current voltage, when the nearly no-load small current value is outputted, has the voltage value V2. This power-supply apparatus can be operated so as to hold the voltage to output the artificial characteristic.

A voltage value Vs on the curve A1 at standard temperature is shifted to Vss in the IV characteristic curve B1 at low temperature. When both the curves are stored, Vss at low temperature is stored. There fore, the artificial characteristic can be outputted corresponding to temperature change. The designated IV curve is read to designate at which current value in the curve power is supplied to the load inverter. The corresponding voltage is thus read to control the voltage value so as to be held.

Optionally, in the solar photovoltaic power generation artificial-power generating method described above, the generation of the control signal, when a current point Y = I1 on one IV curve designated from among the stored IV patterns is instruction set, a voltage X = V1 corresponding to PI on the designated IV curve is read and Y = I1 and X = V1 are automatically set and controlled so as to be a control target set value.

Optionally, in the solar photovoltaic power generation artificial-power generating method described above, in the generation of the control signal, when a load is fluctuated after the current point Y = I1 on the designated IV curve is instruction set, a voltage X = V2 associated with a fluctuated current point Y = 12 is read, Y = 12 and X = V2 are automatically set so as to be a new control target set value, and the output of the direct-current power is controlled so as to trace the designated IV curve.

Hence, a solar photovoltaic power generation simulator power-supply apparatus having the features of claim 1 is provided according to the invention. Further embodiments of the invention are described in the sub-claims.
The solar photovoltaic power generation simulator power-supply apparatus may include: a power conversion main circuit having an input terminal, a converter circuit which changes an alternating current to a direct current, a smoothening capacitor sequentially connected to the output side of the converter circuit, an input current detecting unit, a chopper which performs switching control by a semiconductor switching element, an output voltage detector, an output current detector, and an output terminal; and a control signal circuit which controls the output voltage/output current of the power conversion main circuit. The control signal circuit may have a feedforward control circuit and a feedback control circuit. The feedforward control circuit may feedforward control the power control chopper based on an input current obtained from the input current detecting unit. The feedback control circuit may be a circuit which feedback controls the power control chopper based on an output voltage and an output current obtained from the output voltage detecting unit and the output current detecting unit. The control signal circuit may have an IV storing means for storing, as IV curves, the current/voltage values relation curve which coincides with the output characteristics of a solar battery, an IV curve reading means, a selecting and designating means for selecting and designating one IV curve from among the read IV curves, and a control target value setting means for outputting the current/voltage values characteristic of the designated IV curve.

Optionally, the control target value setting means is a target value setting means including an IV reading means for designating and reading one IV curve from among the stored IV curves, and means, when an instructing person instruction sets an instruction current point Y = I1, for reading a voltage X = V1 associated with a current I1 on the designated IV curve and automatically setting Y = I1 and X = V1 automatically set to the same so as to be a control target value.

Optionally, the generation of the control signal is a target value setting means including means, when a load is fluctuated after the current point Y = I1 on the designated IV curve is instruction set, for reading a voltage X = V2 associated with a fluctuated current point Y = 12 and automatically resetting Y = 12 and X = V2 so as to be a new control target set value.

Optionally, the control signal circuit generates a PWM control signal from a modulation signal and outputs the PWM control signal to the control pole of the semiconductor switching element for power control by the power conversion main circuit, and the modulation signal is a modulation signal generated by adding a signal S1 obtained by amplifying the difference between a direct-current output voltage detection signal and a reference voltage V1 and a signal S2 obtained by amplifying the difference between a direct-current input current and a reference voltage V2.

The solar photovoltaic power generation simulator may have the means for storing, as IV curves, the voltage/current characteristics of solar photovoltaic power generations generated based on the annual fluctuation in the amount of solar irradiation and setting, as the automatic control output target value, the read particular IV characteristic. The solar photovoltaic power generation simulator may have the control signal circuit which generates the control signal which holds a voltage value V associated with a current value I on the particular IV curve, supplies the control signal to the semiconductor switching element which controls the power by the power conversion main circuit including the chopper, and controls the power so as to trace the designated IV curve; and the power conversion main circuit from which series resistors have been eliminated. Therefore, the solar photovoltaic power generation simulator can be a power supply which cannot cause large power loss except for in the semiconductor switching element.

The current/voltage values relation curve from among the output characteristics of the solar battery will be described by illustrating only points necessary for describing the present invention in Fig. 2. A direct-current voltage, when a nearly no-load small current indicated by the dashed line is outputted, is changed from the voltage value V1 to V2 according to the change from the curve A1 to the curve A2. The voltage value is V1 in daytime solar irradiation and is V2 immediately before sunset. The first IV reading means 19 reads the curve A2 from among the IV curves stored in the IV storing means. The second IV reading means 20 reads the voltage value V2 which coincides with the small current. Assuming the inverter operation immediately before sunset, the direct-current voltage, when the nearly no-load small current value is outputted, has the voltage V2. This power-supply apparatus can be operated so as to hold the voltage to output the artificial characteristic.

The voltage value Vs on the curve A1 at standard temperature is shifted to Vss in the IV characteristic curve B1 at low temperature. When both the curves are stored, Vss at low temperature is stored. Therefore, the artificial characteristic can be outputted corresponding to temperature change.

An examplary method for setting an output target value for a feedback control circuit in a solar photovoltaic power generation simulator which may include a power conversion circuit which generates a solar photovoltaic power generation artificial-power, a feedforward control circuit which feedforward controls the power conversion circuit based on an input current of the power conversion circuit, and a feedback control circuit which feedback controls the power conversion circuit based on the output current/voltage of the power conversion circuit. The method may include the following steps:
selecting one IV curve from among a plurality of IV curves generated based on the annual fluctuation in the amount of solar irradiation; and
setting an output target value to the feedback control circuit in order for the feedback control circuit to control the power conversion circuit such that the output characteristic of power control satisfies the selected IV curve.

In the method, the optimal IV curve can be selected from among the plurality of previously prepared IV curves and the output characteristic of power control is controlled so as to coincide with the IV curve.

Optionally, the setting step includes the following steps:
designating a current value on the IV curve selected in the selecting step;
reading a voltage value associated with the current value; and
setting, as the output target value, the current value and the voltage value to the control circuit.

In the method, the voltage value associated with the current value is read so that both of the current value and the voltage value become the output target value, thereby allowing automatic control.

Optionally the designating step designates the current value which coincides with the output current value.

An exemplary computer program may include an instruction for allowing a computer to execute the method according to any one of claims 9 to 11.

The solar photovoltaic power generation simulator may include the computer program described above.

As an example, a device for setting an output target value for a feedback control circuit in a solar photovoltaic power generation simulator includes a power conversion circuit which generates a solar photovoltaic power generation artificial-power, a feedforward control circuit which feedforward controls the power conversion circuit based on the input current of the power conversion circuit, and a feedback control circuit which feedback controls the power conversion circuit based on the output current/voltage of the power conversion circuit. The device may includes: a memory which stores a plurality of IV curves; a reading unit which reads one IV curve from among the plurality of IV curves; and a setting unit which sets an output target value to the feedback control circuit in order for the feedback control circuit to control the power conversion circuit such that the output characteristic of power control satisfies the selected IV curve.

In the device, the reading unit may read one IV curve from the memory, and then, the setting unit may set the output target value for the feedback control circuit. The feedback control circuit may control the power conversion circuit such that the output characteristic of power control satisfies the selected IV curve.

Optionally, the device for setting an output target value for a feedback control circuit in a solar photovoltaic power generation simulator mentioned above further includes an IV curve designating unit which designates an IV curve to be read by the reading unit.

In the device, the IV curve designating unit may designate the IV curve, and then, the reading unit may read the designated IV curve.

Optionally, the device for setting an output target value for a feedback control circuit in a solar photovoltaic power generation simulator mentioned above further includes a current value designating unit which designates a current value on the selected IV curve; and a voltage value reading unit which reads a voltage value associated with the current value.

In the device, the voltage value associated with the current value may be read so that both of the voltage value and the current value become the output target value, thereby allowing automatic control.

Optionally, the device for setting an output target value for a feedback control circuit in a solar photovoltaic power generation simulator mentioned above further includes an operation instructing unit which detects an output current value fluctuated with load fluctuation to provide the current value to the current value designating unit.

As a further example, a solar photovoltaic power generation simulator may include: a power conversion circuit which generates a solar photovoltaic power generation artificial-power; a feedforward control circuit which feedforward controls the power conversion circuit based on the input current of the power conversion circuit; a feedback control circuit which feedback controls the power conversion circuit based on the output current/voltage of the power conversion circuit; and the output target value setting device as described above.

### ADVANTAGEOUS EFFECTS

The output of the solar battery is always fluctuated during the characteristic test of the inverter. The solar battery is thus unsuitable to be used for the input power supply of the inverter as the load. However, the solar battery characteristic can be reproduced in the state that the voltage/current values are stabilized to a desired value.

### BRIEF DESCRIPTION OF DRAWINGS

Fig. 1 is a block diagram of an embodiment according to the present invention.
Fig. 2 is a diagram illustrating the state that the output of a solar photovoltaic power generation panel is fluctuated according to the amount of solar irradiation and temperature.
Fig. 3 is an IV curve diagram of solar photovoltaic power generation characteristics of assistance in explaining an embodiment according to the present invention.
Fig. 4 is an IV curve diagram of solar photovoltaic power generation characteristics of assistance in explaining an embodiment according to the present invention.
Fig. 5 is a block diagram of a power-supply apparatus of a related art (Patent Citation 1).
Fig. 6 is a flowchart of an output target value setting method according to the present invention.

### EXPLANATION OF REFERENCE

1 Constant current source
2 Light-shielded solar battery
3 Non-ohmic resistor
4 Non-ohmic resistor
5 Power receiving end of a commercial power supply
6 Converter circuit
7 Smoothening capacitor
8 Semiconductor switching element
9 Output end of a power conversion main circuit
10 Power control chopper
11 Output voltage detecting unit
12 Output current detecting unit
13 Input current detecting unit
14 Power conversion main circuit
15 Control signal circuit
16 Control target value setting means
17 Target value generating means
18 IV storing means
19 First IV reading means
20 Second IV reading means
21 First error amplifier
22 Second error amplifier
23 First reference value generator
24 Second reference value generator
25 Modulation signal generating circuit
26 PWM control signal generating circuit
28 Switching means
30 IV curve number designating means
31 Current value designating means
40 Operation instructing means
50 Feedback circuit
51 Feedforward circuit

### BEST MODE FOR CARRYING OUT THE INVENTION

An embodiment according to the present invention is illustrated by a block wiring diagram in Fig. 1 and will be described with reference to this. A solar photovoltaic power generation simulator power-supply apparatus has a power conversion main circuit 14 which does not include a resistor for series connection, and a control signal circuit 15. The power conversion main circuit 14 has a power receiving end of a commercial alternating-current power supply 5, a converter circuit 6 which changes an alternating current to a direct current, a smoothening capacitor 7 on the output side of the converter circuit 6, a power control chopper 10 having a semiconductor switching element 8, and an output end of the power conversion main circuit 9. The control signal circuit 15 is connected to an output voltage detecting unit 11, an output current detecting unit 12, and an input current detecting unit 13 from the power conversion main circuit 14 and obtains input signals to the control signal circuit 15. A PWM control signal is supplied from a PWM control signal generating circuit 26 of the control signal circuit 15 to the semiconductor switching element 8. The output characteristic of a solar battery module is artificially generated and outputted from the output end 9 of the power conversion main circuit 14.

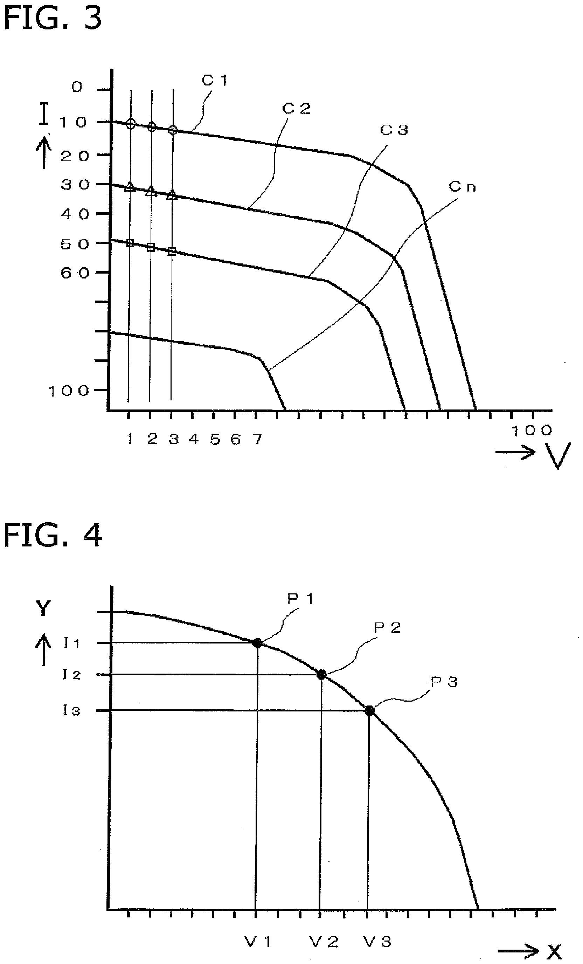

The control signal circuit 15 has a feedback control circuit 50 and a feedforward control circuit 51. Control target value setting means 16 and target value generating means 17 form a control reference value in the feedback control circuit 50. The target value generating means 17 obtains designations of Y = I and X = V on a designated IV curve by signals from an IV storing means 18, a first IV reading means 19, a second IV reading means 20, and an IV curve number designating means 30 to generate a control target value PI (Fig. 4). The target value setting means 16 digital sets a first reference value generator 23 to the control target value P1.

In the feedback control circuit 50, the output signals of the output voltage detecting unit 11 and the output current detecting unit 12 are received as instruction inputs via a switching means 28. The output signal of a first error amplifier 21 which is different from the output signal of the first reference value generator 23 is supplied to a modulation signal generating circuit 25. A drive signal is generated by the PWM control signal generating circuit 26 and is then provided to the control pole of the semiconductor device.

The IV storing means 18 is means for storing a table of the numerical values of the current/voltage values relation curves (IV curves) of the output characteristics of the solar battery. The first IV reading means 19 designates one IV curve designated by the IV curve number designating means 30 from among the stored IV curves. The second IV reading means 20 reads the relation characteristic of a current value and a voltage value on the IV curve to output it to the target value generating means 17. The control target value generating means 17 generates a control target value from the current and voltage values associated with a current value I1 on the designated IV curve to provide and set it to the control target value setting means 16. A practical use example including abnormality during operation will be described.

The feedforward control circuit 51 will be described below. During the actual operation of the solar photovoltaic power generation simulator, when a large current is flowed due to abnormal occurrence, the feedforward control circuit 51 can prevent and suppress a significant sudden drop in output voltage. The feedforward control circuit 51 receives an instruction input from the input current detecting unit 13. The output of a second error amplifier 22 which is different from a second reference value generator 24 is supplied to the modulation signal generating circuit 25. The PWM control signal generating circuit 26 generates a drive signal by a modulation signal. The large current is positively fed back so as to stop the sudden drop in voltage. Therefore, the output voltage is switched from lowering to rise to prevent the significant sudden drop in voltage. The feedback control circuit 50 detects the value of the lowered voltage to provide the drive signal to the control pole of the semiconductor device for control. The response is thus slightly delayed. The large current is positively fed back from the initial stage of rise ahead of this to quickly lessen voltage instantaneous lowering.

The voltage characteristics of solar photovoltaic power generations of assistance in explaining an embodiment according to the present invention will be described by illustrating it in a curve diagram of Fig. 3. The output characteristics of the solar photovoltaic power generation simulator artificially generate Fig. 3. The output of the solar battery module is always fluctuated in solar irradiation, which is unsuitable for measuring the characteristic test. The output characteristic is thus a characteristic value for artificially generating and reproducing the state that solar irradiation is stable during measurement so that inverter input voltage and current values become a desired value. Ten curves are generated based on the annual fluctuation in the amount of solar irradiation in the range of a plane in which current values I are indicated on the Y axis for a curve C1, a curve C2, a curve C3, and a curve Cn, that is, from the curve C1 in strong solar irradiation to the curve Cn in weak solar irradiation and voltage values V are indicated on the X axis. The location point values of 10,000 intersections at which the ten curves provide X points 1 to 100 and Y points 1 to 100 are stored in the IV storing means 18 as the output characteristic curves of the solar battery in which the curves C1, C2, and Cn are plotted. A designated curve (designated IV curve) is read from among the output characteristic curves to be set as a control target value which outputs an artificial curve so as to trace the designated IV curve for controlling the voltage associated with the current at the present point so as to be held. By this method, the artificial power-supply characteristic is generated.

The voltage characteristics of solar photovoltaic power generations of assistance in explaining an embodiment according to the present invention will be described by illustrating it in a curve diagram of Fig. 4. In the generation of a control signal, one of the stored output characteristic curves is a designated IV curve, and when a current point Y = I1 on a designated IV curve is instruction set, a voltage X = V1 corresponding to PI on the designated IV curve is read, and Y = II and X = V1 are automatically set so as to be a control target setting value.

During operation of the power-supply apparatus to which the current point Y = I1 on the designated IV curve C1 is instruction set, when a load (inverter current) is fluctuated, a voltage X = V2 on C1 associated with a fluctuated current point Y = 12 is read, and Y = 12 and X = V2 are automatically set and controlled so as to be a new control target set value. During operation, when the load (inverter current) is further fluctuated, a voltage X = V3 on C1 associated with a fluctuated current point Y = 13 is read, Y = 13 and X = V3 are automatically set so as to be a new control target set value, and the power is controlled so as to trace the designated IV curve. The method for outputting the characteristic of the artificial power supply on the curve C1 corresponding to the load current in which the control target value is fluctuated by the minute is the characteristic technique of the present invention.

The operation of the control signal circuit 15 will be described by the block wiring diagram of Fig. 1. The control signal circuit 15 is connected to the output voltage detecting unit 11, the output current detecting unit 12, and the input current detecting unit 13 from the power conversion main circuit, and obtains input signals for control. To supply the PWM control signal to artificially generate and output the output characteristic of the solar battery module from the output end 9 of the power conversion main circuit, the control signal circuit 15 has the feedback control circuit 50. To form the control reference value, the target value generating means 17 receives a signal which has read the curve C1 of Fig. 3 by signals from the first IV reading means 19 and the IV curve number designating means 30.

Y = I on the designated IV curve is designated by signals from the second IV reading means 20 and current value designating means 31 on the IV curve. Then, the designation of X = V is obtained to generate the control target value PI. The target value setting means 16 digital sets the numerical value of the first reference value generator 23 so as to coincide with the control target value P1. The output signals of the output voltage detecting unit 11 and the output current detecting unit 12 are received as instruction inputs. The output signal of the first error amplifier 21 which is different from the first reference value generator 23 is supplied to the modulation signal generating circuit 25. The drive signal is generated by the PWM control signal generating circuit 26 and is then provided to the control pole of the semiconductor device. The voltage is controlled so as to be maintained by the signal of the feedback control circuit 50.

The IV storing means 18 is means for storing a table of the numerical values of IV relation curves (IV curves) of the output characteristics of the solar battery. The first IV reading means 19 outputs the relation characteristic of the current value and the voltage value on the IV curve designated by the IV curve number designating means 30 which selects and designates the IV curve from among the stored IV curves. The above control procedure is included in software controlled by operation instructing means 40 including a CPU.

The control target value generating means 17 generates the control target value from the current and voltage values corresponding to the current value I1 on the designated IV curve. The control target value setting means 16 sets a set value to the first reference value generator 23.

The set value that the control target value setting means 16 sets to the first reference value generator 23 is a reference value which is compared with a voltage detection value by the first error amplifier 21 and suppresses voltage fluctuation. This is a value in proportion to the output current value I1 at that point and the voltage value V1 associated with it on the designated IV curve.

With respect to the change in instantaneous load (inverter) current, to give consideration to prevent increase in fluctuation in transient control output voltage, feedforward control is added to feedback control to improve the responding speed.

### (DETAILED DESCRIPTION)

The above apparatus and controlling method will be described using another representation. The solar photovoltaic power generation simulator illustrated in Fig. 1 has the power conversion main circuit 14 which generates a solar photovoltaic power generation artificial-power, the feedback control circuit 50 which feedback controls the power conversion main circuit 14 based on the output current and voltage of the power conversion main circuit 14, and an output target value setting device.

The output target value setting device is a device which sets an output target value for the feedback control circuit 50. The device has the IV storing means 18 which stores a plurality of IV curves, the first IV reading means 19 which reads one IV curve from among the plurality of IV curves, and the setting units (16, 17) which set the output target value to the feedback control circuit 50 in order for the feedback control circuit 50 to control the power conversion main circuit 14 such that the output characteristic of power control satisfies the selected IV curve.

In the device, the first IV reading means 19 reads one IV curve from among the IV storing means 18, and then, the setting units (16, 17) set the output target value for the feedback control circuit 50. As a result, the feedback control circuit 50 controls the power conversion main circuit 14 such that the output characteristic of power control satisfies the selected IV curve.

The output target value setting device further has the IV curve number designating means 30 which designates an IV curve to be read by the first IV reading means 19. In the device, the IV curve number designating means 30 designates the IV curve, and then, the first IV reading means 19 reads the designated IV curve.

The output target value setting device further has the current value designating means 31 which designates a current value on the selected IV curve, and the second IV reading means 20 which reads a voltage value associated with the current value. In the device, the voltage value associated with the current value is read so that both of the voltage value and the current value become an output target value, thereby allowing automatic control.

The output target value setting device further has the operation instructing means 40 which detects an output current value fluctuated with load fluctuation to provide the current value to the current value designating means 31.

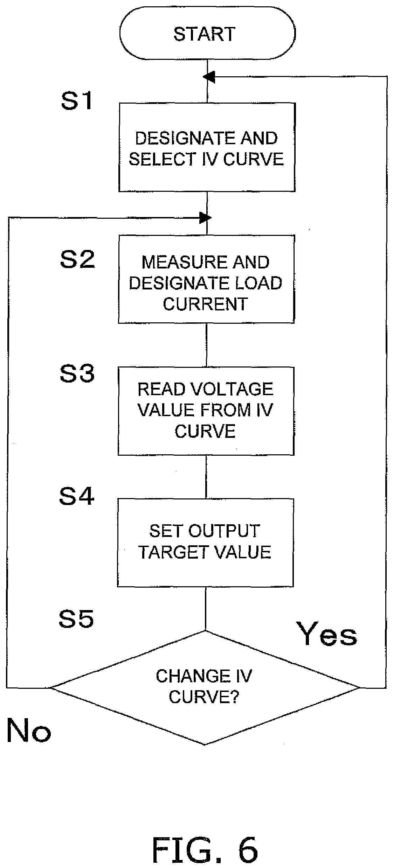

The operation of the output target value setting device will be described using the flowchart of Fig. 6.

In step S1, one IV curve is selected from among a plurality of IV curves. Specifically, the IV curve number designating means 30 designates one IV curve, and then, the first IV reading means 19 reads the IV curve based on it to transmit the information to the control target value generating means 17.

In steps S2 to S4, an output target value is set to the feedback control circuit 50 in order for the feedback control circuit 50 to control the power conversion main circuit 14 such that the output characteristic of power control satisfies the selected IV curve. The optimal IV curve can be selected from among the plurality of prepared IV curves to control the output characteristic of power control so as to coincide with the IV curve.

In step S2, the current value on the IV curve selected in step S1 is designated. Specifically, the operation instructing means 40 measures a load current, and then, the current value designating means 31 designates a current value on the IV curve based on it. The current value which coincides with the output current value is designated.

In step S3, a voltage value associated with the current value is read. Specifically, the second IV reading means 20 reads the voltage value associated with the designated current value on the selected IV curve in the IV storing means 18 to transmit it to the control target value generating means 17.

In step S4, the current value and the voltage value are set, as the output target value, to the feedback control circuit 50. The voltage value associated with the current value is read so that both of the voltage value and the current value become the output target value, thereby allowing automatic control. Specifically, the control target value generating means 17 generates the control target value having the current value and the voltage value to transmit it to the target value setting means 16. The target value setting means 16 sets the control target value to the first reference value generator 23.

In step S5, it is determined whether the IV curve to be selected is changed or not. When it is changed, the routine is returned to step S1. When it is not changed, the routine is returned to step S2. The IV curve to be selected is changed when the operator performs a changing operation in order to generate a solar photovoltaic power generation artificial-power under different solar irradiation conditions.

The above operation can be realized by a computer program as well as hardware such as an electronic circuit. The program includes a command for allowing a computer having a CPU and a memory to execute the above operation.

### INDUSTRIAL APPLICABILITY

The power supply according to the present invention artificially generates and outputs the output characteristic of the solar photovoltaic power generation module. Therefore, the stable load test can be conducted without limiting time. The power supply has the output characteristic of the solar battery which can artificially generate an ideal solar irradiation state. The internal power loss of the power-supply apparatus can be reduced, and thus no measures against heat generation are necessary. Large-capacitance storage battery equipment and resource consumption type equipment such as the solar photovoltaic power generation module are eliminated. Accordingly, the present invention can contribute to social resource saving and has a high degree contributing to the industry.

## Claims

1. A solar photovoltaic power generation simulator power-supply apparatus comprising: a power conversion main circuit (14) having a power receiving end (5) of a commercial power supply, a converter circuit (6) which changes an alternating current to a direct current, a smoothening capacitor (7) sequentially connected to the output side of the converter circuit (6), an input current detecting unit (13), a power control chopper (10) including a semiconductor switching element (8), an output voltage detecting unit (11) for detecting an output voltage of the power conversion main circuit (14), an output current detecting unit (12) for detecting an output current of the power conversion main circuit (14), and an output terminal (9); and a control signal circuit (15) which controls the output voltage and the output current of the power conversion main circuit (14),
the control signal circuit (15) including:
an IV storing means (18) for storing a plurality of IV curves (C1, C2, ... Cn) which are produced based on annual fluctuation in the amount of solar irradiation, each of the IV curves indicating relation between current and voltage satisfying an output characteristic of a solar photovoltaic power generation module;
a first IV reading means (19) for reading an IV curve, designated by an IV curve number designating means (30), from among the plurality of IV curves (C1, C2, ...Cn) stored in the IV storing means (18);
a current value designating means (31) for designating a current value on the read IV curve;
a second IV reading means (20) for reading a voltage value on the read IV curve, associated with the current value designated by the current value designating means (31);
a target value generating means (17) for generating a control target value based on the voltage value read by the second IV reading means (20) and the current value designated by the current value designating means (31);
a feedback control circuit (50) for controlling the semiconductor switching element (8) based on a difference between the control target value and the output voltage/current of the power conversion main circuit (14), the output voltage and the output current being controlled so as to satisfy the read IV curve; and
a feedforward control circuit (51) for controlling the semiconductor switching element (8) based on a difference between an input signal from the input current detecting unit (13) and an output signal from a reference value generator (24).

2. The solar photovoltaic power generation simulator power-supply apparatus according to claim 1, wherein the control signal circuit (15) further includes an operation instructing means (40) for detecting the output current as load current and providing the detected output current to the current value designating means (31),
the current value designating means (31) designates the load current as the current value on the read IV curve.

3. The solar photovoltaic power generation simulator power-supply apparatus according to claim 2, wherein, when the control target value for the feedback control circuit (50) is set based on a current value I1 designated by the current value designating means (31) and then the load current changes, the current value designating means (31) designates a current value I2 on the read IV curve based on the changed current load, reads a voltage value V2 associated with the current value I2, and the target value generating means (17) generates another control target value based on the current value I2 and the voltage value V2.

## Patentansprüche

1. Solar-Photovoltaik-Stromerzeugungs-Simulator-Stromversorgungsvorrichtung mit:
einer Stromumwandlungs-Hauptschaltung (14) mit einem Stromempfangsende (5) einer kommerziellen Stromversorgung, einer Stromrichterschaltung (6), die einen Wechselstrom in einen Gleichstrom umwandelt, einem Glättungskondensator (7), der sequentiell mit der Ausgangsseite der Stromrichterschaltung (6) verbunden ist, einer Eingangsspannungsdetektionseinheit (13), einem Leistungssteuerungszerhacker (10), der ein Halbleiterschaltungselement (8) einschließt, eine Ausgangsspannungsdetektionseinheit (11) zur Detektion von einer Ausgangsspannung der Stromumwandlungs-Hauptschaltung (14), eine Ausgangsstromdetektionseinheit (12) zur Detektion von eines Ausgangsstroms der Stromumwandlungs-Hauptschaltung (14), und ein Ausgangsende (9); und
eine Steuersignalschaltung (15), die die Ausgangsspannung und den Ausgangsstrom der Stromumwandlungs-Hauptschaltung (14) steuert,
wobei die Steuersignalschaltung (15) einschließt:
eine IV-Speichereinrichtung (18) zum Speichern einer Mehrzahl von IV-Kurven (C1, C2, ... Cn) welche erzeugt werden auf der Basis der jährlichen Fluktuation der Sonneneinstrahlungsmenge, wobei jede der IV-Kurven eine Beziehung zwischen Strom und Spannung zeigt, die mit der Ausgangscharakteristik eines Photovoltaik-Stromerzeugungsmoduls übereinstimmt,
einer IV-Leseeinrichtung (19) zum Lesen einer IV-Kurve, die ausgewählt ist durch eine IV-Kurvenzahl-Bestimmungseinrichtung (30), aus einer Mehrzahl von IV-Kurven (C1, C2, ... Cn) die in der IV-Speichereinrichtung (18) gespeichert sind;
eine Stromwertauswahleinrichtung (31) zum Auswählen eines Stromwerts auf der gelesenen IV-Kurve;
eine zweite IV-Leseeinrichtung (20) zum Ablesen eines Spannungswertes auf der gelesenen IV-Kurve, der mit dem durch die Stromwertauswahleinrichtung (31) ausgewählten Stromwert korrespondiert;
eine Zielwerterzeugungseinrichtung (17) zur Erzeugung eines Steuerungszielwerts basierend auf dem durch die zweite IV-Leseeinrichtung (20) abgelesenen Spannungswert und dem durch die Stromwertauswahleinrichtung (31) ausgewählten Stromwert;
eine Feedbacksteuersteuerschaltung (50) zum Steuern des Halbleiterschaltungselements (8) auf der Grundlage einer Differenz zwischen dem Steuerungszielwert und der Ausgabe an Spannung/Strom der Stromumwandlungs-Hauptschaltung (14), wobei die Ausgabespannung und der Ausgabestrom so gesteuert werden, dass sie mit der abgelesenen IV-Kurve übereinstimmen; und
eine Aufschaltungssteuerungsschaltung (51) zum Steuern des Halbleiterschaltungselements (8) auf der Grundlage einer Differenz zwischen einem Eingangssignal von der Eingangsspannungsdetektionseinheit (13) und einem Ausgabesignal von einem Referenzwertgenerator (24).

2. Solar-Photovoltaik-Stromerzeugungs-Simulator-Stromversorgungsvorrichtung nach Anspruch 1, wobei
die Steuersignalschaltung (15) ferner einschließt: Eine Operationsinstruktionseinrichtung (40) zum Detektieren des Ausgabestroms als Laststrom und der Stromwertauswahleinrichtung (31)-Bereitstellen des detektierten Ausgabestoms,
die Stromwertauswahleinrichtung (31) den Laststrom als Stromwert auf der abgelesenen IV-Kurve auswählt.

3. Solar-Photovoltaik-Stromerzeugungs-Simulator-Stromversorgungsvorrichtung nach Anspruch 2, wobei, wenn der Steuerungszielwert für die Feedbacksteuersteuerschaltung (50) eingestellt wird basierend auf einem Stromwert I1 welcher ausgewählt ist durch die Stromwertauswahleinrichtung (31) und dann der Laststrom sich ändert, die Stromwertauswahleinrichtung (31) einen Stromwert I2 auf der abgelesenen IV-Kurve basierend auf dem geänderten Laststrom bestimmt, einen Spannungswert V2 abliest, der mit dem Stromwert I2 verbunden ist, und die Zielwerterzeugungseinrichtung (17) einen anderen Steuerungszielwert basierend auf dem Stromwert I2 und dem Spannungswert V2 erzeugt.

## Revendications

1. Appareil d'alimentation en énergie pour simulateur de génération d'énergie photovoltaïque solaire comprenant: un circuit principal de conversion d'énergie (14) comportant une extrémité de réception d'énergie (5) d'une alimentation électrique commerciale, un circuit convertisseur (6) qui modifie un courant alternatif en un courant continu, un condensateur de lissage (7) connecté séquentiellement au côté sortie du circuit convertisseur (6), une unité de détection de tension d'entrée (13), un hacheur de commande de puissance (10) incluant un élément de commutation de semi-conducteur (8), une unité de détection de tension de sortie (11) pour la détection d'une tension de sortie du circuit principal de conversion d'énergie (14), une unité de détection de courant de sortie (12) pour la détection d'un courant de sortie du circuit principal de conversion d'énergie (14), et un terminal de sortie (9) ; et un circuit des signal de contrôle (15) qui contrôle la tension de sortie et le courant de sortie du circuit principal de conversion d'énergie (14),
le circuit des signal de contrôle (15) incluant :
un moyen de stockage d'IV (18) pour stocker une pluralité de courbes IV (C1, C2, ... Cn) produites sur la base de fluctuation annuelle dans la quantité d'irradiation solaire, chacune des courbes IV indiquant une relation entre courant et tension satisfaisant une caractéristique de sortie d'un module de génération d'électricité photovoltaïque solaire ;
des premiers moyens de lecture d'IV (19) pour lire une courbe IV, désignée par des moyens de désignation de numéro de courbe IV (30) parmi une pluralité de courbes IV (C1, C2, ...Cn) stockée dans le moyen de stockage d'IV (18) ;
des moyens de désignation de valeur de courant (31) pour désigner une valeur de courant sur la courbe IV lue ;
des seconds moyens de lecture d'IV (20) pour lire une valeur de tension sur la courbe IV lue, associée avec la valeur de courant désignée par les moyens de désignation de valeur de courant (31) ;
des moyens de génération de valeur cible (17) pour générer une valeur cible de contrôle sur la base de la valeur de tension lue par les seconds moyens de lecture d'IV (20) et la valeur de courant désignée par les moyens de désignation de valeur de courant (31) ;
un circuit de contrôle de réponse (50) pour contrôler l'élément de commutation de semi-conducteur (8) sur la base d'une différence entre la valeur cible de contrôle et la valeur de tension/courant de sortie du circuit principal de conversion d'énergie (14), la tension de sortie et le courant de sortie étant contrôlé de façon à satisfaire le courbe IV lue ; et
un circuit de contrôle prédictif (51) pour contrôler l'élément de commutation de semi-conducteur (8) sur la base d'une différence entre un signal d'entrée de l'unité de détection de tension d'entrée (13) et un signal de sortie d'un générateur de valeur de référence (24).

2. Appareil d'alimentation en énergie pour simulateur de génération d'énergie photovoltaïque solaire selon la revendication 1, dans lequel le circuit des signal de contrôle (15) en outre comprend des moyens d'instruction d'opération (40) pour détecter le courant de sortie en tant que courant de charge et pourvoir le courant de sortie détecté aux moyens de désignation de valeur de courant (31),
les moyens de désignation de valeur de courant (31) désignent le courant de charge comme étant la valeur de courant sur la courbe IV lue.

3. Appareil d'alimentation en énergie pour simulateur de génération d'énergie photovoltaïque solaire selon la revendication 2, dans lequel, quand le circuit de contrôle de réponse (50) est configurée sur la base d'une valeur de courant I1 désignée les moyens de désignation de valeur de courant (31) et ensuite le courant de charge change, les moyens de désignation de valeur de courant (31) désignent une valeur de courant I2 sur la courbe IV lue sur la base du courant de charge changé, lisent un valeur de tension V2 associé à la valeur de courant I2, et les moyens de génération de valeur cible (17) génèrent une autre valeur cible de contrôle sur la base de la valeur de courant I2 et la valeur de tension V2.
